# EUROPÄISCHE PATENTANMELDUNG

(11) **EP 3 092 927 A1**
(43) Veröffentlichungstag der Anmeldung: **16.11.2016**
(21) Anmeldenummer: 16168712.4
(22) Anmeldetag: 09.05.2016
(51) Int. Cl.: A47K 13/30

(54) **TOILETTENSITZ SOWIE DAMIT AUSGESTATTETE SANITÄREINRICHTUNG**

(30) Priorität: 11.05.2015 DE 102015107335
(71) Anmelder: Villeroy & Boch AG, 66693 Mettlach (DE)
(72) Erfinder: Terner, Mark, 66798 Wallerfangen (DE); Rau, Heiko Armin, 66265 Heusweiler (DE)
(74) Vertreter: Kilchert, Jochen

(57) **Zusammenfassung**

Die Erfindung betrifft einen Toilettensitz (1) zur Anbringung an einer Toilettenschüssel (2) mit einer Beleuchtungseinrichtung (3), wobei der Toilettensitz (1) wenigstens eine einen Aufnahmeraum definierende, insbesondere nutförmige, Ausnehmung zur Aufnahme wenigstens eines Leuchtmittels (7) und/oder wenigstens eine an einer Peripherie (19, 22) der Toilettensitzes (1) angeordnete Lichtleiste (23) mit wenigstens einem Leuchtmittel (7), aufweist sowie eine mit einem solchen Toilettensitz ausgestattete Sanitäreinrichtung.

## Beschreibung

Die Erfindung betrifft einen Toilettensitz gemäß dem Oberbegriff des Patentanspruchs 1 sowie eine mit einem solchen Toilettensitz ausgestattete Sanitäreinrichtung gemäß dem Oberbegriff des Patentanspruchs 16.

Toilettensitze sind als Bestandteil von Toiletten seit langer Zeit bekannt. Üblicherweise befinden sich diese Toiletten im Badezimmer eines Hauses oder in einem separaten Raum. Sofern ein Benutzer die Toilette nachts benutzen möchte, ist es üblicherweise notwendig in dem betreffenden Raum Licht einzuschalten. Dies ist für viele Benutzer, insbesondere nachts, sehr störend, da die Raumbeleuchtung einerseits die an Dunkelheit gewöhnten Augen eines Benutzers blendet und der Benutzer darüber hinaus durch das helle Raumlicht unnötig wach wird. Aus diesem Grund wurden in der Vergangenheit dezente Nachtlichter unterschiedlichster Art entwickelt, wobei ein Ansatz u.a. darin besteht ein Nachtlicht in einem WC zu integrieren. Üblicherweise wird hierzu eine Lampe in den Sitz oder Deckel eines WCs integriert, um auf diese Weise den Nutzungsbereich der Toilette zu beleuchten. Diese Ansätze weisen jedoch unterschiedliche Nachteile auf. So ist oft nur eine einzelne Lampe, d.h. eine punktförmige oder punktförmig wirkende Lichtquelle unter dem Toilettensitz oder dem Toilettendeckel angebracht, was, insbesondere bei geschlossenem Toilettendeckel zu einer schlechten Beleuchtung oder, insbesondere bei geöffnetem Toilettendeckel, zu einer den Benutzer blendenden Beleuchtung führt. Darüber hinaus benötigen bisherige Beleuchtungsvorrichtungen für Toiletten oft Zusatzkomponenten, wie beispielsweise Batteriepacks, eine Steuereinheit, gegebenenfalls einen Bewegungsschalter sowie unter Umständen diverse Klammern und eine Verkabelung, die bei aus dem Stand der Technik bekannten WCs an der Toilette angebracht werden müssen. Diese Lösungen sind nicht nur optisch unschön, sondern auch schwierig sauber zu halten bzw. zu reinigen, womit oft ein Hygieneproblem einhergeht. Des Weiteren sind seit einiger Zeit Dusch-WCs bekannt, die oft ein integriertes LED-Licht haben. Dieses Licht ist jedoch beim Stand der Technik im hinteren Bereich des WCs angeordnet, sodass dieses LED-Licht nur wenig Licht bietet, insbesondere dann wenn der Toilettendeckel geschlossen ist. Aus diesem Grund ist es nicht immer möglich diese oft zu dunkle Beleuchtung für weitere Tätigkeiten im Badezimmer, wie beispielsweise fürs Händewaschen, zu nutzen.

Ein weiterer Nachteil bisheriger an einer Toilette angebrachter Beleuchtungsvorrichtungen besteht auch darin, dass das in den Toilettensitz oder in den Toilettendeckel integrierte Licht von einem Benutzer der Toilette bei der Benutzung der Toilette verdeckt wird, sodass der Raum um die Toilette, beispielsweise in Richtung Toilettenpapier, nur noch unzureichend ausgeleuchtet wird.

Ein weiterer Ansatz zur dezenten Beleuchtung der Umgebung einer Toilette sowie des Raums, in welchem die Toilette aufgestellt ist, besteht darin, dass spezielle fluoreszierende oder phosphoreszierende Materialien in den Toilettenkörper oder deren Teile integriert werden, die dann bei Dunkelheit ein entsprechendes dezentes Licht emittieren. Diese Lösung ist jedoch aufgrund der zu verwendenden Materialien teuer und deshalb wenig praktikabel. Darüber hinaus haben die fluoreszierenden bzw. phosphoreszierenden Materialien nur eine begrenzte Fluoreszenz-bzw. Phosphoreszenzdauer und müssen durch eine externe Lichtquelle regelmäßig quasi aufgeladen werden.

Die Nachteile des Standes der Technik lassen sich somit wie folgt zusammenfassen. Eine im hinteren Bereich des WCs oder Dusch-WCs angebrachte punktuelle Lichtquelle bietet nur ungenügend Licht für eine Benutzung des Badezimmers, der Toilette, oder von Toilettenpapier sowie des Waschbeckens zum Händewaschen. Darüber hinaus kann eine hinter dem Toilettensitz befindliche Lichtquelle, insbesondere bei einem geschlossenen Toilettendeckel, den umgebenden Raum nur unzureichend beleuchten; dies gilt insbesondere auch dann, wenn die Toilette durch einen Benutzer in Benutzung ist. Eine an der Seite eines Dusch-WCs oder einer Toilette angeordnete punktförmige Lichtquelle ist ebenfalls zumeist nicht zur ausreichenden Ausleuchtung eines Badezimmers oder anderen Raums geeignet; darüber hinaus besteht die Gefahr einer Blendung eines Benutzers aufgrund der punktuellen Lichtemission durch die punktförmige Lichtquelle, die in ihrem Zentrum sehr hell ist. Darüber hinaus stören außen an der Toilette angeordnete Lichtquellen den optischen Eindruck und die Ästhetik, respektive das Design, einer Toilette. Etwaige benötigte Zusatzkomponenten haben denselben negativen Effekt, wenn diese an der Toilettenschüssel angebracht werden müssen.

Der Erfindung liegt die Aufgabe zugrunde die oben genannten Probleme zu lösen und einen Toilettensitz, respektive eine Sanitäreinrichtung zur Verfügung zu stellen, die eine dezente, jedoch dennoch raumfüllende Beleuchtung eines Badezimmers oder eines anderen Raums, in welchem eine Toilette aufgestellt ist, ermöglicht und die darüber hinaus einfach und kostengünstig herstellbar sowie bequem bedienbar und steuerbar ist.

Diese Aufgabe wird durch einen Toilettensitz gemäß Patentanspruch 1 sowie durch eine Sanitäreinrichtung gemäß Patentanspruch 16 gelöst.

Insbesondere wird die Aufgabe durch einen Toilettensitz zur Anbringung an einer Toilettenschüssel mit einer Beleuchtungseinrichtung gelöst, wobei der Toilettensitz wenigstens eine einen Aufnahmeraum definierende, insbesondere nutförmige, Ausnehmung zur Aufnahme wenigstens eines Leuchtmittels und/oder wenigstens eine an einer Peripherie der Toilettensitzes angeordnete Lichtleiste mit wenigstens einem Leuchtmittel, aufweist.

Ein wesentlicher Punkt der Erfindung besteht darin, dass der erfindungsgemäße Toilettensitz so ausgebildet ist, dass rand- bzw. oberflächenseitig in den Toilettensitz ein Leuchtmittel eingesetzt werden kann. Zu diesem Zweck ist erfindungsgemäß ein Aufnahmeraum für das Leuchtmittel vorgesehen. Dieser Aufnahmeraum kann in Form einer Nut ausgebildet sein. Unter einer Nut ist erfindungsgemäß eine längliche Ausnehmung zu verstehen, in welcher entweder ein lang gestrecktes Leuchtmittel oder mehrere Leuchtmittel eingesetzt werden können. Aufgrund der Tatsache, dass das oder die Leuchtmittel in dem Aufnahmeraum angeordnet sind, wird das von einem Benutzer wahrgenommene emittierte Licht des Leuchtmittels indirekt, d.h. unter Reflexion an den Aufnahmeraumwänden, in den Raum abgestrahlt, sodass eine Blendwirkung eines Benutzers der Toilette praktisch ausgeschlossen ist, solange ein Benutzer nicht absichtlich direkt in die Nut, d.h. in den Aufnahmeraum, der die Lichtquelle beherbergt, schaut, was jedoch nicht im Rahmen einer üblichen Benutzung einer Toilette liegt.

Die Verwendung einer Lichtleiste, die entlang einer Peripherie des Toilettensitzes angeordnet ist, kann alternativ oder zusätzlich zur Anbringung einer Lichtquelle in dem vorerwähnten Aufnahmeraum erfolgen, wobei die Lichtleiste das oder die jeweiligen Leuchtmittel enthält und Lichtaustrittsöffnungen aufweist, die im Wesentlichen in den Raum, respektive in Richtung Boden gerichtet sind, so dass auch bei Verwendung einer Lichtleiste eine Blendung eines Benutzers der Toilette im normalen Gebrauch der Toilette erfindungsgemäß ausgeschlossen ist.

Gemäß einer bevorzugten Ausführungsform der Erfindung weist der Toilettensitz ein Gehäuse mit einer äußeren Wandung und einer inneren Wandung auf, wobei die äußere Wandung eine äußere Peripherie und die innere Wandlung eine innere Peripherie definiert, wobei die äußere Wandung entlang ihrer äußeren Peripherie eine einen äußeren Aufnahmeraum definierende äußere nutförmige Ausnehmung zur Aufnahme wenigstens eines Leuchtmittels aufweist und/oder die innere Wandung entlang ihrer inneren Peripherie eine einen inneren Aufnahmeraum definierende innere nutförmige Ausnehmung zur Aufnahme wenigstens eines Leuchtmittels aufweist und/oder der Toilettensitz eine entlang der äußeren Peripherie angeordnete Lichtleiste mit wenigstens einem Leuchtmittel aufweist.

Ein wichtiger Punkt der Erfindung besteht ferner darin, dass der erfindungsgemäße Toilettensitz ein Gehäuse aufweist, das einstückig ausgebildet oder aus mehreren Komponenten zusammengesetzt sein kann.

Das Gehäuse weist eine äußere Wandung auf, die eine äußere, d.h. radial außen liegende, Peripherie des Toilettensitzes definiert. Dieser äußeren Peripherie des Toilettensitzes gegenüberliegend befindet sich eine innere, d.h. eine in radialer Richtung bezüglich der äußeren Peripherie weiter innen liegende, Wandung des Toilettensitzes, die einem zentralen Freiraum des Toilettensitzes und gegebenenfalls dem Inneren der Toilettenschüssel zugewandt ist. Diese innere Wandung definiert ihrerseits eine innere Peripherie des Toilettensitzes. Die äußere Peripherie des Toilettensitzes erstreckt sich somit im Wesentlichen entlang der Außenseite des Toilettensitzes zumindest jedoch entlang dessen seitlicher sowie vorderer Begrenzung, während sich die innere Peripherie des Toilettensitzes entlang der inneren Begrenzung des sich in dem Toilettensitz befindlichen zentralen Freiraums des Toilettensitzes erstreckt. Der Begriff "radial" ist im Sinne der Erfindung nicht als kreisförmig rund, sondern entsprechend einer üblichen Toilettensitzform zu verstehen, d.h. im Wesentlichen mehr oder weniger oval und gegebenenfalls mit Ecken versehen.

Erfindungsgemäß kann gemäß einer bevorzugten Ausführungsform der Erfindung sowohl entlang der äußeren Peripherie in der äußeren Wandung als auch entlang der inneren Peripherie in der inneren Wandung jeweils eine nutförmige Ausnehmung angeordnet sein.

Gemäß einer besonders bevorzugten Ausführungsform der Erfindung ist diese nutförmige Ausnehmung insbesondere entlang der äußeren Peripherie an der äußeren Wandung ausgebildet. In diese nutförmige Ausnehmung ist erfindungsgemäß ein Leuchtmittel eingesetzt. Das Leuchtmittel ist seinerseits in dieser nutförmigen Ausnehmung fixiert und/oder, beispielsweise mit einem Kunstharz in dieser nutförmigen Ausnehmung umgossen sowie gegebenenfalls auf diese Weise in das Kunstharz eingebettet.

In gleicher Weise kann ein Leuchtmittel in der inneren Wandung des erfindungsgemäßen Toilettensitzes angeordnet sein. Auch dieses Leuchtmittel kann in dem durch die nutförmige Ausnehmung definierten inneren Aufnahmeraum fixiert und, nach Wunsch, ebenfalls mit Kunstharz umgossen sein.

Gemäß einer Ausführungsform der Erfindung kann die nutförmige Ausnehmung entweder nur in der äußeren Wandung des Toilettensitzes oder nur in der inneren Wandung des Toilettensitzes ausgebildet sein, wobei betont wird, dass auch eine Kombination von zwei nutförmigen Ausnehmungen, nämlich einmal entlang der äußeren Peripherie des Toilettensitzes in der äußeren Wandung und darüber hinaus zusätzlich entlang der inneren Peripherie in der inneren Wandung des Toilettensitzes, im Umfang der Erfindung liegt. Selbiges gilt auch für eine oder mehrere Nut(en), die sich auf, respektive in, der Oberseite und/oder auf, respektive in, der Unterseite und/oder beispielsweise spiralförmig um den Querschnitt des Toilettensitzes erstrecken können.

Darüber hinaus ist es erfindungsgemäß vorgesehen, dass eine Lichtleiste wenigstens ein Leuchtmittel aufweist, wobei die Lichtleiste entlang der äußeren Peripherie des Toilettensitzes und/oder, allerdings nicht bevorzugt, entlang der inneren Peripherie des Toilettensitzes an diesem angebracht sein kann. Des Weiteren können sich die oder mehrere Lichtleiste(n) auch an der Ober- und/oder Unterseite des erfindungsgemäßen Toilettensitzes erstrecken. Insbesondere in den letzteren beiden Fällen ist die Lichtleiste besonders flach ausgebildet oder in die jeweilige Oberfläche versenkt bzw. eingelassen, um einerseits eine glatte Auflage des Toilettensitzes auf der Toilettenschüssel und andererseits ein angenehmes Sitzgefühl sicherzustellen.

Auch im Hinblick auf die erfindungsgemäße Verwendung einer Lichtleiste sei darauf hingewiesen, dass diese erfindungsgemäß entweder in Alleinstellung oder in Kombination mit der oder den nutförmigen Ausnehmung(en), insbesondere mit der äußeren nutförmigen Ausnehmung und/oder mit der inneren nutförmigen Ausnehmung, verwendet werden kann.

Erfindungsgemäß ist die äußere nutförmige Ausnehmung in Richtung der äußeren Peripherie und/oder die innere nutförmige Ausnehmung in Richtung der inneren Peripherie jeweils von einem wenigstens abschnittsweise transparenten oder teiltransparenten Wandabschnitt begrenzt, wobei die jeweilige Ausnehmung insbesondere durch diesen Wandabschnitt gegenüber der äußeren Peripherie und/oder gegenüber der inneren Peripherie abgeschlossen ist.

Gemäß einer Alternative der Erfindung ist dieser Wandabschnitt als montierbare, insbesondere austauschbare, Leiste ausgebildet, mit welcher die jeweilige nutförmige Ausnehmung nach einem Einsatz des Leuchtmittels nach außen, d.h. insbesondere gegenüber der äußeren Wandung oder gegenüber der inneren Wandung, verschlossen werden kann und die Wandung nach einem Einsetzen der Leiste somit eine glatte, nach Wunsch kantenfreie, Fläche ergibt.

Als Leuchtmittel wird erfindungsgemäß wenigstens eine LED, bevorzugt ein LED-Band mit einer Vielzahl von voneinander beabstandet angeordneten LEDs verwendet. Alternativ kann einzeln oder in Kombination mit den LEDs auch ein Lichtleiter mit einer oder mehreren Lichtquellen und/oder eine Lichtröhre verwendet werden, die beispielsweise mit einem zum Leuchten anregbaren Medium, beispielsweise Gas, gefüllt ist.

Gemäß einer bevorzugten Ausführungsform der Erfindung werden die Leuchtmittel so in der jeweiligen nutförmigen Ausnehmung, respektive dem inneren Aufnahmeraum und/oder dem äußeren Aufnahmeraum angeordnet, dass eine Leuchtwirkung im Wesentlichen entlang der gesamten Länge der jeweiligen nutförmigen Ausnehmung erreicht wird. Zu diesem Zweck werden bevorzugt mehrere LEDs beabstandet voneinander in dem jeweiligen Aufnahmeraum angeordnet, sodass sich deren Lichtemission entlang der gesamten jeweiligen nutförmigen Ausnehmung erstreckt.

Um eine Blendwirkung durch die jeweiligen LEDs, des Lichtleiters oder der Lichtröhre sowie etwaiger anderer Lichtquellen für einen Benutzer zu vermeiden, sind die jeweiligen Leuchtmittel in der äußeren und/oder in der inneren nutförmigen Ausnehmung und/oder in der Lichtleiste wenigstens teilweise, bevorzugt in Richtung der jeweiligen Außenseite der Nut(en), insbesondere in Richtung der äußeren und/oder inneren Peripherie von einem lichtstreuenden, insbesondere als optischer Diffusor wirkenden Material, umgeben, insbesondere mit diesem vergossen. Als optischer Diffusor kann erfindungsgemäß ein Kunstharz, ein Lack, Papier oder eine dünne, d.h. durchscheinende Feststoffschicht, dienen. Im Fall der Verwendung eines Kunstharzes kann dieses eine Lichtstreuung begünstigende Additive, wie beispielsweise Feststoffpartikel und/oder Gasblasen, beispielsweise Luftblasen, enthalten.

In vorteilhafter Weise wird somit erfindungsgemäß erreicht, dass entlang der gesamten nutförmigen Ausnehmung(en), insbesondere in der inneren Wandung und/oder in der äußeren Wandung, sowie nach Wunsch entlang der Lichtleiste, homogen und gleichförmig Licht abgestrahlt wird, das zur Beleuchtung der Toiletten sowie des umgebenden Raums, insbesondere Badezimmers, ausreichend, aber dennoch dezent und nicht blendend ist.

Die jeweilige nutförmige Ausnehmung, respektive der jeweils durch diese definierte Aufnahmeraum, ist nach außen glatt entweder durch eine transluzente lichtbrechende Leiste oder durch ein Gussmaterial begrenzt. Das Gussmaterial kann ein Kunstharz, entsprechend vorstehenden Erläuterungen, sein, das um die jeweiligen Leuchtmittel gegossen ist.

Gemäß einer bevorzugten Ausführungsform der Erfindung ist hierbei die gesamte nutförmige Ausnehmung mit dem Gussmaterial verfüllt. Des Weiteren sei darauf hingewiesen, dass ein entsprechendes Gussmaterial auch in Kombination mit einer Leiste verwendet werden kann. In diesem Fall sind die Leuchtmittel zunächst mit dem Gussmaterial vergossen und anschließend ist die nutförmige Ausnehmung nach außen mit der Leiste verschlossen, wobei die Leiste außen an das Gussmaterial angesetzt ist und die jeweilige Wandung nach außen glatt abschließt. In diesem Fall kann die die nutförmige Ausnehmung nach außen abschließende Leiste auch aus einem glasklaren Material bestehen, dass selbst keine Lichtbrechung, respektive nur eine geringe Lichtbrechung, aufweist, so das die Leiste nach außen eine spiegelnde Oberfläche hat. Auf diese Weise kann erfindungsgemäß ein besonders ansprechender optischer Effekt erzielt werden. Darüber hinaus sei an dieser Stelle erwähnt, dass sowohl das Gussmaterial als auch die Leiste jeweils aus einem weißen oder farbigen, gegebenenfalls mehrfarbigen Material bestehen können oder ein solches buntes Material zumindest abschnittsweise oder in Teilchenform aufweisen können.

Erfindungsgemäß sind die Leiste und/oder zumindest der Rahmen der Lichtleiste aus einem Kunststoff hergestellt. Als Kunststoffe kommen hierbei bevorzugt insbesondere Polytetrafluorethylen (PTFE), Polyethylen, Polypropylen, Polycarbonat, Silikon(e) und/oder Polyethylen sowie Polyethylenterephtalat infrage. Als weitere Materialien eignen sich ferner Glas, insbesondere Milchglas, sowie gegebenenfalls ein textiles Flächengebilde. Des Weiteren kann sowohl die Leiste als auch die Lichtleiste eine Schicht aus Papier enthalten, durch welche das austretende Licht hindurch strahlt. Alle genannten Materialien können weiß oder gefärbt sein, so dass das durch sie hindurch strahlende Licht weiß oder farbig erscheint.

Als Gussmaterial kommen die genannten Kunststoffe ebenfalls in Betracht.

Gemäß einer weiteren Ausführungsform der Erfindung können die Leiste und/oder die Lichtleiste Bereiche unterschiedlicher Transparenz aufweisen. Auf diese Weise weist das durch die Leiste und/oder durch entsprechende Lichtaustrittsflächen der Lichtleiste austretende Licht eine unterschiedliche Intensität auf. So können die Leiste und/oder die jeweiligen Lichtaustrittsflächen der Lichtleiste beispielsweise einen Schriftzug aufweisen, der, insbesondere bei eingeschaltetem Licht, gut erkennbar ist. Dieser Schriftzug kann beispielsweise ein Logo sein. Auch ein einfaches Muster kann auf diese Weise dargestellt werden, wobei die Art des Musters prinzipiell frei wählbar ist. Diesbezüglich sei betont, dass die Bereiche unterschiedlicher Transparenz nicht auf zwei unterschiedliche Lichtdurchlässigkeiten der Leiste bzw. der Lichtaustrittsflächen der Lichtleiste begrenzt sind, sondern beliebig viele Lichtdurchlässigkeitabstufungen möglich sind.

Ebenso sei darauf hingewiesen, dass eine nach Wunsch verwendete Gussmasse, mit welcher das jeweilige Leuchtmittel zumindest in Richtung einer Lichtaustrittsöffnung umhüllt ist, ebenfalls unterschiedlich gefärbt sein kann oder einen Farbverlauf aufweisen kann. Auch die jeweiligen Lichtdurchlässigkeiten der Gussmasse können einen Verlauf aufweisen.

Erfindungsgemäß kann der Toilettensitz einteilig ausgebildet sein. Darüber hinaus kann der Toilettensitz jedoch auch als Gehäuse ausgebildet sein oder ein solches aufweisen. Ein solches Gehäuse weist wenigstens ein oberes Gehäuseteil und wenigstens ein anderes Gehäuseteil auf, die miteinander, gegebenenfalls über Zwischenglieder, verbunden sind.

Gemäß einer bevorzugten Ausführungsform der Erfindung weist ein erfindungsgemäßes Gehäuse zumindest abschnittsweise einen transparenten oder teiltransparenten Gehäuseabschnitt auf, der als Lichtaustrittsfläche dienen kann.

Dieser transparente oder teiltransparente Gehäuseabschnitt kann entweder als Leiste entsprechend vorstehender Ausführungen ausgebildet sein. Darüber hinaus ist es möglich, dass der transparente oder teiltransparente Gehäuseabschnitt in Form einer dünnen Gehäusewandung vorliegt, durch welche, aufgrund einer reduzierten Wandstärke des Gehäuses, Licht austreten kann. In diesem Zusammenhang ist es beispielsweise möglich die innere Wandung des Toilettensitzes mit einer tiefen Nut zu versehen, die sich bis nahezu an die äußere Wandung des Toilettensitzes erstreckt, und in welcher ein Leuchtmittel angeordnet ist. Dieses Leuchtmittel kann sodann durch den transparenten oder teiltransparenten Gehäuseabschnitt entlang der äußeren Peripherie des Toilettensitzes hindurch strahlen, der dadurch gebildet ist, dass die Gehäusewandung entlang dieser äußeren Peripherie, respektive entlang des transparenten oder teiltransparente Gehäuseabschnitts so dünn gewählt ist, dass Licht durch das Material des Toilettensitzes hindurch treten kann. Des Weiteren kann das Material des Toilettensitzes im Wesentlichen durchsichtig sein und/oder mit einer durchscheinenden Farbe, insbesondere einem Lack beschichtet sein, der innerhalb oder außerhalb des Gehäuses, respektive in der nutförmigen Ausnehmung oder außen an der Wandung des Toilettensitzes, aufgebracht sein kann. Des Weiteren kann die nutförmige Ausnehmung an ihrer Innenseite zur Erhöhung der Lichtausbeute mit einer reflektierenden Beschichtung, beispielsweise einer Verspiegelung, versehen sein.

In diesem Zusammenhang sei ferner erwähnt, dass es ebenso im Umfang der Erfindung liegt, in radialer Richtung mehrere Leuchtmittel in die Nut einzusetzen, beispielsweise ein Leuchtmittel nahe der äußeren Peripherie und ein weiteres Leuchtmittel nahe der inneren Peripherie, d.h. nahe an der Ausgangsöffnung der Nut, die nach einem Einsetzen der Leuchtmittel und gegebenenfalls einem Vergießen derselben mit einem Gussmaterial verschlossen wird. Diesbezüglich sei darauf hingewiesen, dass die Nut vollständig mit Gussmaterial aufgefüllt sein kann oder alternativ lediglich die jeweiligen Leuchtmittel mit Gussmaterial umhüllt sowie gegebenenfalls mit dem Gussmaterial fixiert sein können.

Gemäß einer alternativen Ausführungsform der Erfindung kann die Nut auch in der äußeren Wandung des Toilettensitzes ausgebildet sein und sich bis nahezu an die innere Peripherie des Toilettensitzes erstrecken, wobei entlang der inneren Peripherie ein dünner Wandbereich verbleibt, der einen transparenten oder teiltransparenten Gehäuseabschnitt des Toilettensitzgehäuses darstellt. Auch die Unter- und/oder Oberseite des erfindungsgemäßen Toilettensitzes kann analog gestaltet sein.

Des Weiteren ist erfindungsgemäß vorgesehen, dass der transparente oder teiltransparente Wandabschnitt eine gegenüber der übrigen Wandung, insbesondere dem wenigstens einen unteren und/oder dem wenigstens einen oberen Gehäuseteil, eine erhöhte Lichtdurchlässigkeit aufweist. Auf diese Weise erstreckt sich entlang der inneren und/oder der äußeren Peripherie des Toilettensitzes ein Lichtband, während aus den übrigen Teilen bzw. Flächen des Toilettensitzgehäuses kein Licht oder Licht mit geringer bis sehr geringer Intensität austritt.

Vorzugsweise sind sowohl der untere als auch der obere Gehäuseteil des erfindungsgemäßen Toilettensitzes opak ausgebildet, so das bei Dunkelheit nur das sich, insbesondere entlang der inneren und/oder der äußeren Peripherie des Toilettensitzes, erstreckende Lichtband sichtbar ist. Als Lichtband wird in diesem Zusammenhang auch die Lichtleiste verstanden, die sich entlang der Außenseite des Toilettensitzes erstrecken kann.

Die Lichtleiste kann relativ flach oder in Form eines Rohres ausgebildet sein, das einen eckigen oder runden, respektive ovalen Querschnitt aufweist. Die jeweiligen Leuchtmittel sind erfindungsgemäß in dem Rohr angeordnet. Es kann sich hierbei um ein Leuchtgas, herkömmliche Glühlampen oder LEDs handeln. Eine elektrische Kontaktierung der Lichtleiste erfolgt vorzugsweise an der Rückseite des Toilettensitzes, beispielsweise über die Scharniere des Toilettensitzes. In gleicher Weise kann auch eine elektrische Kontaktierung der Leuchtmittel erfolgen, die in der oder den jeweiligen Nuten, d.h. insbesondere in der inneren und/oder äußeren Wandung, des Toilettensitzes ausgebildet sind.

In diesem Zusammenhang sei darauf hingewiesen, dass eine Nut, die beispielsweise entlang der äußeren Peripherie des Toilettensitzes in der äußeren Wandung ausgebildet ist, durchgängig sein oder Unterbrechungen aufweisen kann, sodass tatsächlich anstelle einer langen Nut mehrere kurze Nuten in der äußeren Wandung ausgebildet sein können. Des Weiteren können in den jeweiligen Nuten auch etwaige Verstärkungsstege vorgesehen sein, die das Gehäuse des erfindungsgemäßen Toilettensitzes stabilisieren.

Die Lichtleiste kann ihrerseits entweder außenseitig der Wandung des Toilettensitzes, bevorzugt entlang von dessen äußerer Peripherie, nach Wunsch jedoch auch entlang von dessen innerer Peripherie, angebracht sein. Diesbezüglich bietet sich beispielsweise ein Ankleben der Lichtleiste an der entsprechenden Wandung an. Alternativ kann die Lichtleiste jedoch auch zumindest teilweise in eine hierfür vorgesehene Nut eingesetzt und in dieser fixiert sein.

Wie vorerwähnt erstreckt sich die äußere nutförmige Ausnehmung wenigstens entlang einer vorderen und seitlichen äußeren Peripherie des erfindungsgemäßen Toilettensitzes, während der hintere, d.h. der dem Scharnier zugewandte Teil des Toilettensitzes keine Nut aufweist. Nach Wunsch kann sich die äußere nutförmige Ausnehmung jedoch auch bis nahe an das Scharnier oder um dieses herum erstrecken, sodass die äußere nutförmige Ausnehmung den Toilettensitz entlang dessen äußerer Peripherie vollständig umläuft.

Entsprechend kann sich die innere nutförmige Ausnehmung entlang der inneren Peripherie des erfindungsgemäßen Toilettensitzes lediglich über Teilbereiche der inneren Peripherie erstrecken oder die innere Peripherie vollständig umlaufen.

Erfindungsgemäß ist die äußere nutförmige Ausnehmung und/oder die innere nutförmige Ausnehmung und/oder die Lichtleiste in einem unteren Abschnitt des Toilettensitzes entlang der Peripherie des Toilettensitzes und gegebenenfalls in einem Winkel zur Vertikalen angeordnet, so dass im Gebrauch Licht aus der jeweiligen Ausnehmung und/oder der Lichtleiste im Wesentlichen nach unten in Richtung eines Bodens und/oder in das Innere der Toilettenschüssel, insbesondere blendfrei, abgestrahlt wird.

So kann sich die jeweilige nutförmige Ausnehmung beispielsweise nicht horizontal in den sich im Gebrauch befindlichen, d.h. horizontal angeordneten, Toilettensitz in dessen jeweilige Wandung hinein erstrecken, sondern die jeweilige nutförmige Ausnehmung kann so in der jeweiligen Wandung angeordnet sein, dass sich der Nutboden oberhalb der Nutöffnung befindet und sich die Nut, ausgehend von der Nutöffnung in einem Winkel leicht nach oben erstreckt, so dass aus der Nut durch die Nutöffnung austretendes Licht nicht horizontal, sondern leicht nach unten gerichtet aus der Nut austritt. Auf diese Weise ist in sehr vorteilhafter und einfacher Weise sichergestellt, dass ein Benutzer durch das aus der Nut austretende Licht keinesfalls geblendet wird, der die Toilette umgebende Boden jedoch gut ausgeleuchtet ist.

Sofern Licht durch einen nach Wunsch vorgesehenen transparenten oder teiltransparenten Gehäuseabschnitt hindurch scheint, der dadurch erzeugt ist, dass das Gehäuseteil an dieser Stelle eine reduzierte Wandstärke aufweist, ist eine Blendwirkung erfindungsgemäß ausgeschlossen, da die Intensität des durch die Wandung des Toilettensitzgehäuses hindurchstrahlenden Lichts so weit gedämpft ist, dass eine Blendung eines Benutzers praktisch nicht möglich ist.

Erfindungsgemäß verlaufen die äußere nutförmige Ausnehmung und/oder die innere nutförmige Ausnehmung und/oder die Lichtleiste entlang der äußeren und/oder der inneren Peripherie des Toilettensitzes linienförmig, insbesondere im Wesentlichen geradlinig lineare, wellenförmig, mäanderförmig, geschwungen oder zickzackförmig.

Diesbezüglich ist es möglich ein entsprechend der Form der nutförmigen Ausnehmung verlaufendes Lichtband zu erzeugen, dass entlang der äußeren Peripherie dieselbe oder eine andere Form haben kann als entlang der inneren Peripherie.

Gemäß einer Ausführungsform der Erfindung ist das Leuchtmittel mittels eines Sensors, beispielsweise Licht- oder Dämmerungssensors, und/oder mittels einer Fernbedienung steuerbar sowie gegebenenfalls dimmbar. Als Sensor kommt beispielsweise ein Bewegungsmelder in Betracht, der als Schalter für das Leuchtmittel dient und eine Beleuchtung durch das Leuchtmittel aktiviert, sobald eine Person den Raum betritt oder in die Reichweite des Bewegungsmelder gelangt. Darüber hinaus kann die Beleuchtung auch über einen Lichtsensor, wie beispielsweise einen Dämmerungssensor, aktiviert werden, sobald eine vorhandene Beleuchtung unter ein bestimmtes Niveau abfällt. Auf diese Weise kann die Helligkeit des von dem Toilettensitz emittierten Lichts auf die Helligkeit des umgebenden Lichts abgestimmt werden, sodass es beispielsweise möglich ist einen "sanften Nachtmodus" für das von dem Toilettensitz abgestrahlte Licht einzustellen und auf diese Weise die Gefahr einer Blendwirkung für einen Benutzer weiter zu reduzieren. Ferner kann die Beleuchtung auch durch eine Fernbedienung gesteuert und/oder gedimmt werden, die einem Benutzer zur Verfügung steht.

Des Weiteren wird die erfindungsgemäße Aufgabe durch eine Sanitäreinrichtung, insbesondere Toilette, mit einem Toilettensitzes gemäß vorstehenden Ausführungen gelöst.

Erfindungsgemäß weist die Toilette einen Toilettendeckel auf, dessen vorderer und/oder seitlicher unterer Rand in geschlossenem Zustand beabstandet zu einer Toilettenschüssel angeordnet ist, sodass von dem Toilettensitz abgestrahltes Licht durch einen Spalt zwischen Toilettendeckel und Toilettenschüssel in den Raum strahlt.

Die Erfindung stellt somit ein verbessertes Beleuchtungssystems für WCs da. Ein besonderer Vorteil der Erfindung besteht darin, dass durch die Verwendung des erfindungsgemäßen Toilettensitzes eine ausreichende Beleuchtung zur Verfügung gestellt wird, die ausreicht sowohl das WC zu finden und zu bedienen sowie zu benutzen, als auch um andere Aktivitäten im Badezimmer, wie beispielsweise Händewaschen, zu erledigen. Dies wird dadurch ermöglicht, dass bei eingeschalteter Beleuchtung, insbesondere entlang der äußeren und/oder inneren Peripherie, des erfindungsgemäßen Toilettensitzes ein Lichtband erzeugt wird, durch welches ein blendfreies Licht in den die Toilette umgebenden Raum und/oder in die Toilettenschüssel hinein abgestrahlt wird. Die Beleuchtung ist erfindungsgemäß in den Toilettensitz integriert und benötigt keine Zusatzkomponenten, die außerhalb des Toilettensitzes an diesem oder an der Toilettenschüssel, respektive dem Toilettendeckel angebracht werden müssten. Somit wird das Design der mit einem solchen erfindungsgemäßen Toilettensitz ausgestatteten Toilette nicht gestört. Darüber hinaus ermöglicht die erfindungsgemäße Ausgestaltung des Toilettensitzes eine einfache Reinigung des Toilettensitzes, respektive der Toilette, sodass eine einwandfreie Hygiene eingehalten werden kann. Durch die umlaufende Beleuchtung des Toilettensitzes ist ferner gewährleistet, dass auch dann, wenn ein Benutzer die Toilette benutzt, genügend Licht in den die Toilette umgebenden Raum fällt, so das ein Benutzer in der Lage ist, beispielsweise das Toilettenpapier oder die Fernbedienung des Dusch-WCs zu finden und zu bedienen. Im Übrigen ist es aufgrund der erfindungsgemäßen vorteilhaften Ausgestaltung des Toilettensitzes nicht notwendig teure und teils exotische Materialien, wie beispielsweise fluoreszierende oder phosphoreszierende Komponenten zu verwenden, um eine Beleuchtung zu erzeugen. In diesem Zusammenhang sei jedoch darauf hingewiesen, dass auch derartige fluoreszierende und/oder phosphoreszierende Bestandteile in den erfindungsgemäßen Toilettensitz integriert werden können, sofern dies gewünscht ist. Es handelt sich hierbei jedoch allenfalls um eine Zusatzmaßnahme und ist zur Ausführung der Erfindung nicht notwendig.

Darüber hinaus sei darauf hingewiesen, dass das bei eingeschalteter Beleuchtung entlang der inneren und/oder äußeren Peripherie des erfindungsgemäßen Toilettensitzes erzeugte Lichtband eine homogene und gleichmäßige Ausleuchtung, respektive Beleuchtung, ermöglicht. Durch das transluzente Material, in welches die jeweiligen Leuchtmittel eingebettet sind, oder durch welches das Licht aus dem äußeren und/oder inneren Aufnahmeraum und/oder aus der Lichtleiste in Richtung eines Benutzers fällt, ist ferner sichergestellt, dass das Lichtband nicht als Folge einzelner Lichtpunkte erscheint, sondern als gleichmäßig ausgeleuchtetes Lichtband. Die an einer Lichtkette punktuell angeordneten LED-Lampen sind somit nicht als einzelne Lichtpunkte, sondern als einheitliches Lichtband wahrzunehmen.

Ein gegebenenfalls notwendiges Netzteil sowie eine elektronische Steuerung, die in Kombination mit einem Lichtsensor oder einen Kippsensor zur Änderung der Lichthelligkeit verwendet werden kann, sind erfindungsgemäß in der Toilette, beispielsweise im Fuß der Toilette integriert. Auf diese Weise kann mittels einer elektronischen Steuerung die Lichtintensität, die von dem erfindungsgemäßen Toilettensitz emittiert wird, so geregelt werden, dass diese reduziert wird, wenn die Umgebungshelligkeit gering und das Auge an einem geringen Lichteinfall adaptiert ist oder wenn der Toilettendeckel hochgeklappt ist, da in letzterem Fall ein Lichtausfall aus dem erfindungsgemäßen Toilettensitz nicht durch den Toilettendeckel behindert wird.

Ein weiterer wichtiger Vorteil, der mit der Erfindung einhergeht, besteht auch darin, dass das Gehäuse des erfindungsgemäßen Toilettensitzes mit Standardspritzgussmaterialien hergestellt werden kann.

Der erfindungsgemäße Toilettensitz kann grundsätzlich für alle Arten von WCs verwendet werden. Hierbei zählen insbesondere bodenstehende und wandhängende sowie nicht-stationäre WCs, beispielsweise in Zügen, auf Schiffen, in Autobussen oder anderen mobilen Einrichtungen. Eine Stromversorgung kann entweder in die erfindungsgemäße Sanitäreinrichtung integriert sein oder von extern erfolgen.

Weitere Ausführungsformen der Erfindung ergeben sich aus den Unteransprüchen.

Nachfolgend wird die Erfindung anhand von Ausführungsbeispielen beschrieben, die anhand der Abbildungen näher erläutert werden. Hierbei zeigen:
- Fig. 1: eine schematische Darstellung einer erfindungsgemäßen Sanitäreinrichtung mit abgehobenem Toilettendeckel;
- Fig. 2: eine schematische Darstellung des Querschnitts einer Ausführungsform eines erfindungsgemäßen Toilettensitzes gemäß Fig. 1;
- Fig. 3: eine schematische Darstellung der erfindungsgemäßen Sanitäreinrichtung gemäß Fig. 1 mit geschlossenem Toilettendeckel;
- Fig. 4-5: eine schematische Darstellung einer Ausführungsform der Erfindung in Anlehnung an Fig. 2;
- Fig. 6: eine schematische Darstellung einer weiteren Ausführungsform der Erfindung in Querschnittsansicht;
- Fig. 7: eine schematische Darstellung einer Ausführungsform der Erfindung in Querschnittsansicht mit einem in einer Nut des Toilettensitzes angeordneten Leuchtmittel;
- Fig. 8: eine schematische Darstellung einer weiteren Ausführungsform der Erfindung in Querschnittsansicht;
- Fig. 9: eine schematische Darstellung der Ausführungsform gemäß Fig. 8 in perspektivische Ansicht; und
- Fig. 10: eine schematische Darstellung der Lichtwirkung eines erfindungsgemäßen Toilettensitzes gemäß der Ausführungsform aus den Fig. 2-5.

In der nachfolgenden Beschreibung werden für gleiche und gleich wirkende Teile dieselben Bezugsziffern verwendet.

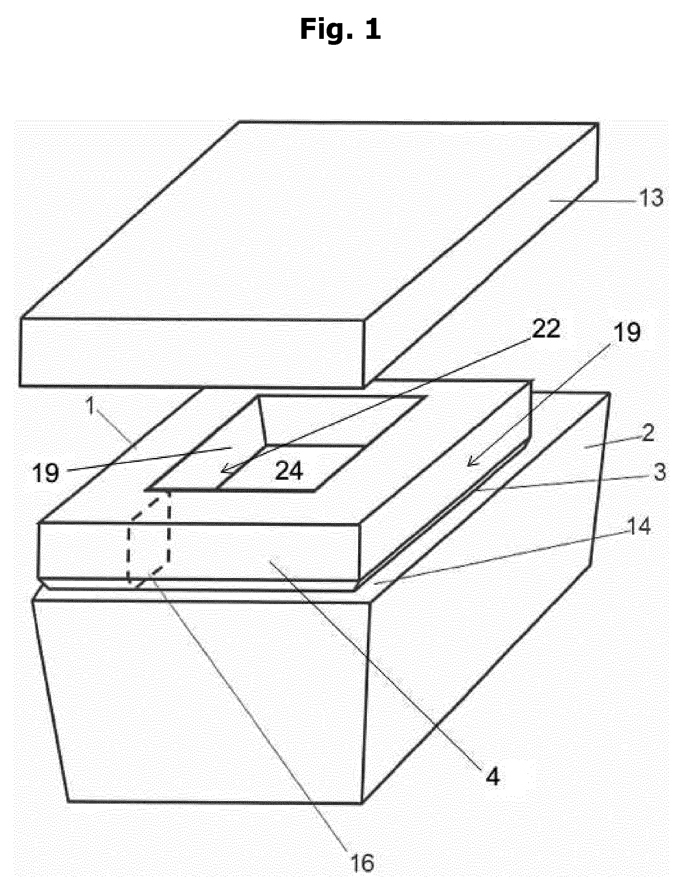

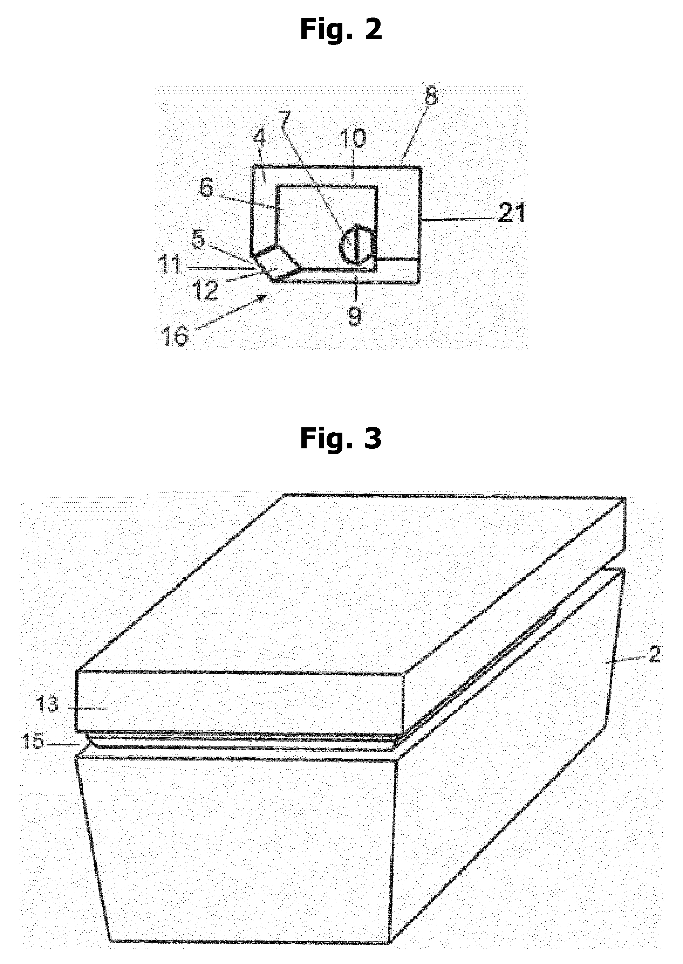

Fig. 1 zeigt eine schematische Darstellung einer erfindungsgemäßen Sanitäreinrichtung, nämlich einer Toilette, die einen auf einer Toilettenschüssel 2 angeordneten Toilettensitz 1 aufweist. Ferner ist in Fig. 1 ein Toilettendeckel 13 dargestellt, der von der Toilettenschüssel 2 abgehoben ist. Der Toilettensitz 1 ist in schematischer Darstellung gezeigt. Der Toilettensitz 1 weist eine äußere Wandung 4 und eine innere Wandlung 21 auf. Entlang der äußeren Wandung 4 erstreckt sich eine äußere Peripherie 19. Entlang der inneren Wandung 21 erstreckt sich eine innere Peripherie 22, die ihrerseits eine innere Begrenzung des sich in dem Toilettensitz 1 befindlichen zentralen Freiraums 24 des Toilettensitzes 1 darstellt. Der Toilettensitz 1 umfasst eine Beleuchtungseinrichtung 3, die in einem unteren Bereich des Toilettensitzes 1 oberhalb eines Randes 14 der Toilettenschüssel 2 angeordnet ist. Im vorderen Bereich von Fig. 1 ist mit gestrichelten Linien ein Querschnitt 16 dargestellt, der in Fig. 2 in vergrößerter Darstellung in Querschnittsansicht gezeigt ist.

Aus Fig. 2 ist zu erkennen, dass der erfindungsgemäße Toilettensitz 1 ein Gehäuse 8 umfasst, dass aus einem unteren Gehäuseteil 9 und einem oberen Gehäuseteil 10 sowie einer Leiste 12 gebildet ist. Der Toilettensitz 1 weist seinerseits eine dem zentralen Freiraum 24 zugewandte innere Wandung 21 sowie eine einem sich nähernden Benutzer zugewandte äußere Wandung 4 auf. Zwischen der inneren Wandung 21 und der äußeren Wandung 4 befindet sich ein Aufnahmeraum 6, in welchem ein Leuchtmittel 7 angeordnet ist. Im dargestellten Fall ist der Aufnahmeraum 6 als Hohlraum ausgebildet, der entweder hohl ausgebildet oder mit einem Gussmaterial, wie beispielsweise einen Kunststoff, verfüllt sein kann. Das obere Gehäuseteil 10 ist gemäß Fig. 2 im Wesentlichen U-förmig ausgebildet. Das obere Gehäuseteil 10 bildet mit dem unteren Gehäuseteil 9 und der Leiste 12 das Gehäuse 8 des Toilettensitzes 1, wobei die Leiste 12 einen transparenten oder teiltransparenten Gehäuseabschnitt 11 definiert. Dieser transparente oder teiltransparente Gehäuseabschnitt 11 stellt einen Wandabschnitt 5 des Gehäuses 8 danach, durch welchen Licht, das von dem in dem Aufnahmeraum 6 angeordneten Leuchtmittel 7 emittiert wird, aus dem Gehäuse 8 austreten kann. Die Leiste 12 ist in einem unteren Bereich des Gehäuses 8 angeordnet und so ausgerichtet, dass das Licht in abwärts gerichteter Richtung aus dem Gehäuse 8 austritt, sodass ein sich der Toilette nähernder Benutzer durch das aus dem Gehäuse 8 austretende Licht nicht geblendet wird.

Fig. 3 zeigt die Ausführungsform gemäß Fig. 1 in schematische Darstellung, wobei gemäß Fig. 3 der Toilettendeckel 13 auf die Toilette, d.h. auf den Toilettensitz 1 abgesenkt ist. Zwischen Toilettendeckel 13 und Toilettenschüssel 2 verbleibt ein Spalt 15 aus welchem das von dem Toilettensitz 1 emittierte Licht austreten kann.

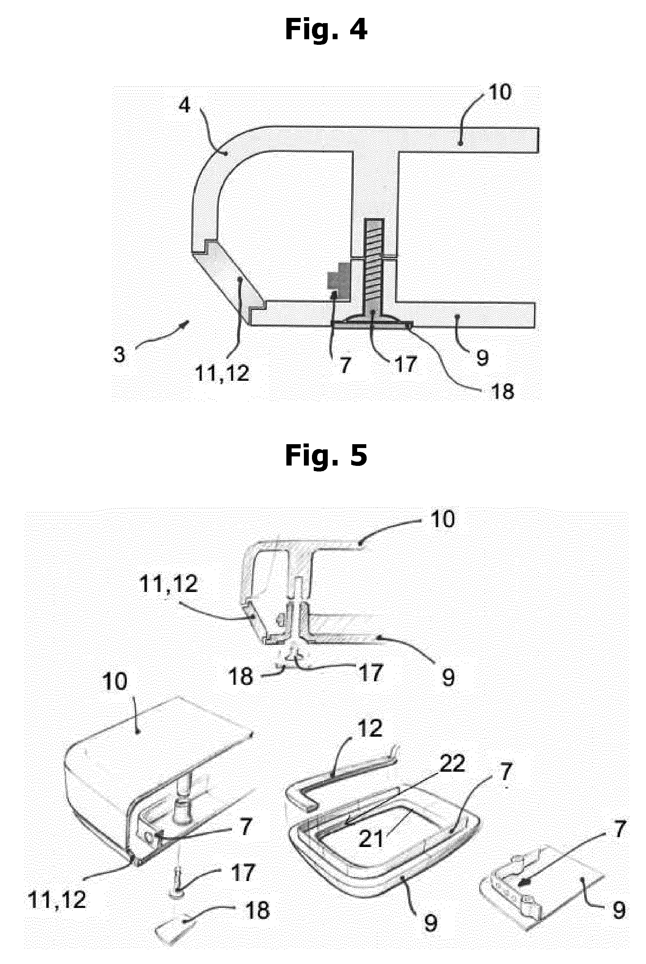

Die Fig. 4-5 zeigen eine schematische Darstellung einer Ausführungsform der Erfindung in Anlehnung an Fig. 2. So ist gemäß Fig. 4 ein Abschnitt eines Toilettensitzes 1 gezeigt, der aus einem oberen Gehäuseteil 10 und einem unteren Gehäuseteil 9 zusammengefügt ist. Der obere Gehäuseteil 10 ist hierbei über einen im Wesentlichen senkrechten Steg mit dem unteren Gehäuseteil 9 verbunden, wobei eine Schraube 17 von unten in den Steg des unteren Gehäuseteil 9 eingeschraubt ist und sich in den dem oberen Gehäuseteil 10 zugeordneten Teil des Stegs fortsetzt und auf diese Weise das untere Gehäuseteil 9 und das obere Gehäuseteil 10 aneinander fixiert. Die Schraube 17 ist durch eine Schraubenabdeckung 18 verdeckt. Des Weiteren ist in Fig. 4 eine äußere Wandung 4 gezeigt, die als Verlängerung des oberen Gehäuseteil 10 ausgebildet ist, die sich über den vorderen Rand des Toilettensitzes 1 erstreckt. In ihrem vorderen unteren Bereich bildet die Wandung 4 zusammen mit dem unteren Gehäuseteil 9 eine äußere nutförmige Ausnehmung 20, in welcher ein Leuchtmittel 7 angeordnet ist. Die nutförmige Ausnehmung 20 ist gemäß Fig. 4 als Hohlraum ausgebildet und an ihrem vorderen Rand, respektive ihrer Öffnung mit einer Leiste 12 verschlossen, welche einen transparenten Gehäuseabschnitt 11 bildet. Somit bildet die in Fig. 4 dargestellte Einheit eine Beleuchtungseinrichtung 3, die entlang der vorderen und seitlichen Peripherie des Toilettensitzes 1 Licht abstrahlen kann, so das die Toilette sowie der die Toilette umgebende Raum beleuchtet wird.

Fig. 5 zeigt nähere Details der in Fig. 4 dargestellten Ausführungsform, insbesondere wie neben der Leiste 12 das Leuchtmittel 7 in den erfindungsgemäßen Toilettensitz 1 integriert ist. Das Leuchtmittel 7 stellt hierbei ein LED-Band dar, dass eine Vielzahl von LEDs nebeneinander und beabstandet voneinander aufweist. Gemäß Fig. 5 ist der erfindungsgemäße Toilettensitz 1 somit aus 3 Gehäuseteilen, nämlich einem unteren Gehäuseteil 9 und einem oberen Gehäuseteil 10 sowie der Leiste 12 zusammengesetzt, wobei auf dem unteren Gehäuseteil 10 ein U-förmig verlaufendes LED-Band, das senkrecht auf dem unteren Gehäuseteil 10 fixiert ist, verläuft, so dass entsprechend dem U-förmigen Verlauf des LED-Bandes Licht aus dem Toilettensitz 1 abgestrahlt werden kann, wenn die Beleuchtungseinrichtung 3 aktiviert ist. Entsprechend dem U-förmigen Verlauf des LED-Bandes ist die transparente Leiste 12 zwischen dem unteren Gehäuseteil 9 und dem oberen Gehäuseteil 10 im vorderen Bereich des Gehäuses 8, respektive des erfindungsgemäßen Toilettensitzes 1 angeordnet. Im hinteren, d.h. einem Scharnierbereich zugeordnet Abschnitt des Toilettensitzes 1 ist gemäß der in Fig. 5 dargestellten Ausführungsform kein Leuchtmittel 7 vorgesehen.

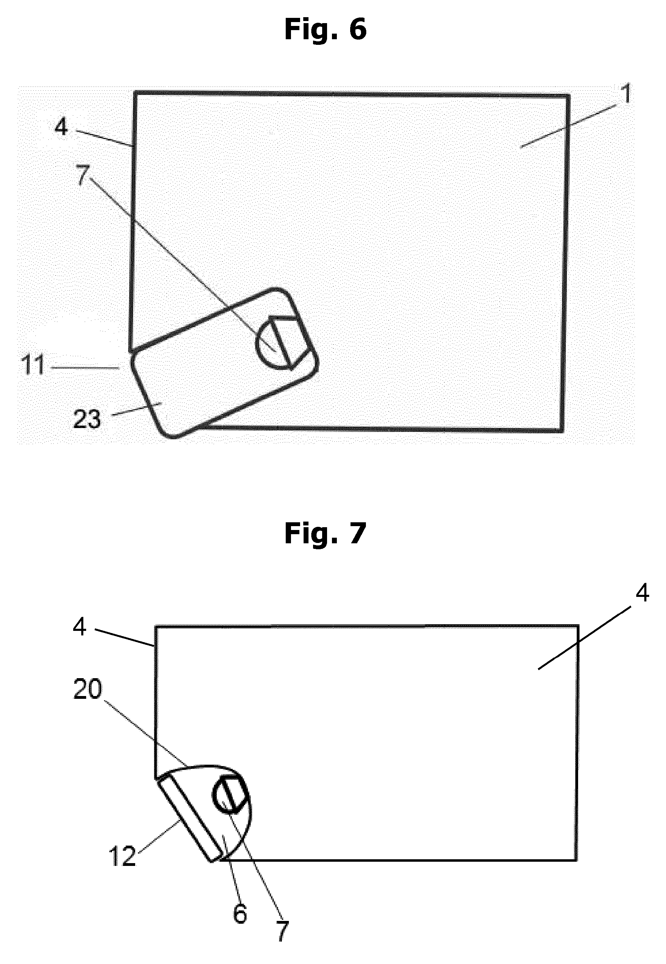

Fig. 6 zeigt in schematischer Darstellung eine weitere Ausführungsform der Erfindung, bei welcher eine Lichtleiste 23 in eine nutförmige Ausnehmung, die einen Aufnahmeraum 6 bildet, eingesetzt ist. Die Lichtleiste 23 umfasst ein an ihrem hinteren Ende angeordnetes Leuchtmittel 7 und stellt einen transparenten Gehäuseabschnitt 11 dar. Die Lichtleiste 23 ist in die nutförmige Ausnehmung eingesetzt und darin fixiert. Dies kann beispielsweise durch Verkleben realisiert sein.

Fig. 7 zeigt eine Variante einer erfindungsgemäßen Ausführungsform, bei welcher ein Leuchtmittel 7 in einer äußeren nutförmigen Ausnehmung 20 angeordnet ist. Der durch die nutförmige Ausnehmung 20 gebildete Aufnahmeraum 6 ist auf seiner der äußeren Wandung 4 zugewandten Seite mit einer Leiste 12 verschlossen, durch welche von dem Leuchtmittel 7 abgestrahltes Licht aus dem Toilettensitz 1 heraus abgestrahlt wird.

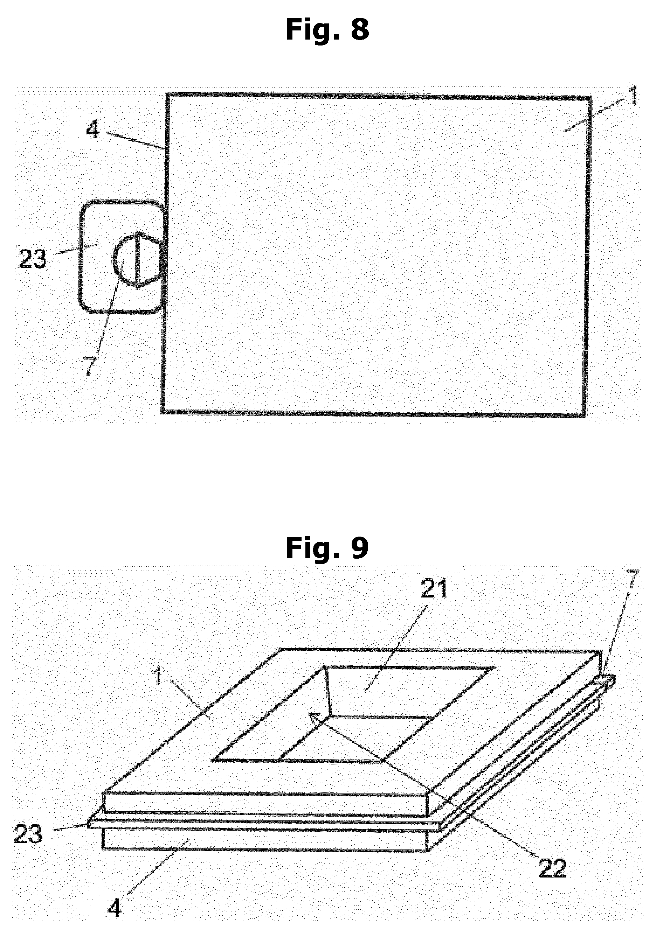

Fig. 8 zeigt in schematischer Darstellung eine weitere Ausführungsform der Erfindung, bei der eine Lichtleiste 23 an einer äußeren Wandung 4 des erfindungsgemäßen Toilettensitzes angebracht ist. Die Lichtleiste 4 ist gemäß Fig. 8 nicht in eine äußere nutförmige Ausnehmung eingesetzt, wie dies beispielsweise in Fig. 6 dargestellt ist, sondern außen auf die äußere Oberfläche der äußeren Wandung 4 geklebt. In der Lichtleiste 23 befindet sich wiederum ein Leuchtmittel 7 in Form einer LED, die Teil eines LED-Bandes ist, das sich längs der rohrförmig Lichtleiste erstreckt. Die Lichtleiste ist flexibel gestaltet, sodass sie an jedwede Toilettensitzform angepasst und daran befestigt werden kann. Selbiges gilt für die in Fig. 6 dargestellte Lichtleiste 23.

Fig. 9 zeigt einen erfindungsgemäßen Toilettensitz 1 in perspektivische Ansicht, der eine Lichtleiste 23 aufweist, die außenseitig entlang der äußeren Wandung 4 des Toilettensitzes 1 angebracht ist. An einem Ende der Lichtleiste 23 befindet sich ein Leuchtmittel 7, dass, anders als in den Fig. 6 und Fig. 8, bei welchen LEDs im Inneren der Lichtleiste 23 angeordnet sind, Licht in die Lichtleiste 23 einspeist. Hierfür wird eine herkömmliche Glühlampe oder, bevorzugt eine LED, verwendet. Eine entsprechende Lichteinspeisung kann, nach Wunsch, auch an dem entgegengesetzten Ende der Lichtleiste 23 vorgesehen sein.

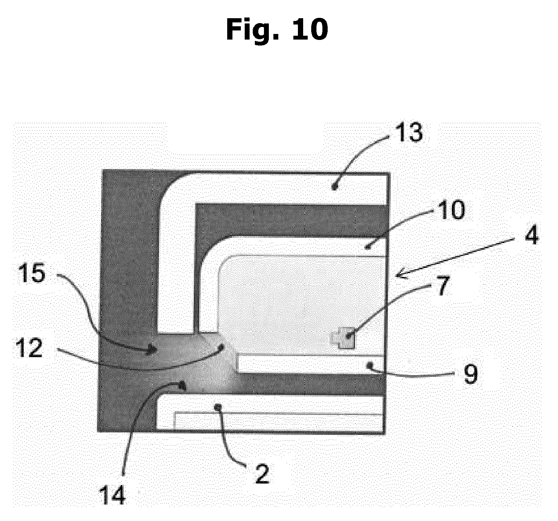

Fig. 10 zeigt eine schematische Darstellung der Lichtwirkung des erfindungsgemäßen Toilettensitzes, respektive der erfindungsgemäßen Sanitäreinrichtung. So ist in Fig. 10 eine Toilettenschüssel 2 dargestellt, auf welcher sich ein Toilettensitz 1 befindet, der in seinem vorderen Bereich eine äußere nutförmige Ausnehmung aufweist, die aus einem oberen Gehäuseteil 10, einem unteren Gehäuseteil 9 und einer Leiste 12 gebildet wird. Ein Toilettendeckel 13 ist über den erfindungsgemäßen Toilettensitz 1 abgesenkt, jedoch nur soweit, dass ein Spalt 15 verbleibt, aus welchem Licht austreten kann, dass von dem Leuchtmittel 7 erzeugt wird und durch die Leiste 12 in Richtung des Randes 14 der Toilettenschüssel 2 fällt.

An dieser Stelle sei darauf hingewiesen, dass alle oben beschriebenen Teile für sich alleine gesehen und in jeder Kombination, insbesondere die in den Zeichnungen dargestellten Details als erfindungswesentlich beansprucht werden. Abänderungen hiervon sind dem Fachmann geläufig.

### Bezugszeichenliste

- 1: Toilettensitz
- 2: Toilettenschüssel
- 3: Beleuchtungseinrichtung
- 4: äußere Wandung
- 5: Wandabschnitt
- 6: Aufnahmeraum
- 7: Leuchtmittel
- 8: Gehäuse
- 9: unterer Gehäuseteil
- 10: oberer Gehäuseteil
- 11: transparenter oder teiltransparenter Gehäuseabschnitt
- 12: Leiste
- 13: Toilettendeckel
- 14: Rand
- 15: Spalt
- 16: Querschnitt
- 17: Schraube
- 18: Schraubenabdeckung
- 19: äußere Peripherie
- 20: äußere nutförmige Ausnehmung
- 21: innere Wandung
- 22: innere Peripherie
- 23: Lichtleiste
- 24: zentraler Freiraum

## Patentansprüche

1. Toilettensitz (1) zur Anbringung an einer Toilettenschüssel (2) mit einer Beleuchtungseinrichtung (3),
**dadurch gekennzeichnet, dass**
der Toilettensitz (1) wenigstens eine einen Aufnahmeraum definierende, insbesondere nutförmige, Ausnehmung zur Aufnahme wenigstens eines Leuchtmittels (7) und/oder wenigstens eine an einer Peripherie (19, 22) der Toilettensitzes (1) angeordnete Lichtleiste (23) mit wenigstens einem Leuchtmittel (7), aufweist.

2. Toilettensitz nach Anspruch 1,
**dadurch gekennzeichnet, dass**
der Toilettensitz (1) ein Gehäuse (8) mit einer äußeren Wandung (4) und einer inneren Wandung (21) aufweist, wobei die äußere Wandung (4) eine äußere Peripherie (19) und die innere Wandung (21) eine innere Peripherie (22) definiert, wobei die äußere Wandung (4) entlang ihrer äußeren Peripherie (19) eine einen äußeren Aufnahmeraum (6) definierende äußere nutförmige Ausnehmung (20) zur Aufnahme des wenigstens einen Leuchtmittels (7) aufweist und/oder die innere Wandung (21) entlang ihrer inneren Peripherie (22) eine einen inneren Aufnahmeraum definierende innere nutförmige Ausnehmung zur Aufnahme des wenigstens einen Leuchtmittels (7) aufweist und/oder der Toilettensitz (1) eine entlang der äußeren Peripherie (19) angeordnete Lichtleiste (23) mit dem wenigstens einen Leuchtmittel (7) aufweist.

3. Toilettensitz nach einem der vorhergehenden Ansprüche,
**dadurch gekennzeichnet, dass** das Leuchtmittel (7) in der äußeren nutförmigen Ausnehmung (20) und/oder in der inneren nutförmigen Ausnehmung und/oder in der Lichtleiste (23) angeordnet ist.

4. Toilettensitz nach einem der vorhergehenden Ansprüche,
**dadurch gekennzeichnet, dass** die äußere nutförmige Ausnehmung (20) in Richtung der äußeren Peripherie (19) und/oder die innere nutförmige Ausnehmung in Richtung der inneren Peripherie (22) jeweils von einem wenigstens abschnittweise transparenten oder teiltransparenten Wandabschnitt (5) begrenzt ist, wobei die jeweilige Ausnehmung insbesondere durch diesen Wandabschnitt (5) gegenüber der äußeren Peripherie (19) und/oder der inneren Peripherie (22) geschlossen ist.

5. Toilettensitz nach Anspruch 4,
**dadurch gekennzeichnet, dass** der Wandabschnitt (5) als montierbare, insbesondere austauschbare, Leiste (12) ausgebildet ist.

6. Toilettensitz nach einem der vorhergehenden Ansprüche,
**dadurch gekennzeichnet, dass** das Leuchtmittel (7) in der äußeren (20) und/oder in der inneren nutförmigen Ausnehmung und/oder in der Lichtleiste (23) wenigstens teilweise, bevorzugt jeweils in Richtung der jeweiligen äußeren (19) oder inneren Peripherie (22) von einem lichtstreuenden, insbesondere als optischer Diffusor wirkenden Material, umgeben, insbesondere mit diesem vergossen, ist.

7. Toilettensitz nach einem der vorhergehenden Ansprüche, insbesondere nach einem der vorhergehenden Ansprüche 5 bis 6,
**dadurch gekennzeichnet, dass**
die Leiste (12) und/oder die Lichtleiste (23) einen Kunststoff, insbesondere Polytetrafluorethylen (PTFE), Polyethylen, Polypropylen, Polycarbonat, Silikon oder Polyethylenterephtalat, und/oder Glas, insbesondere Milchglas, und gegebenenfalls ein textiles Flächengebilde und/oder Papier aufweist und/oder zumindest teilweise daraus hergestellt ist.

8. Toilettensitz nach einem der vorhergehenden Ansprüche 5 bis 7,
**dadurch gekennzeichnet, dass**
die Leiste (12) und/oder die Lichtleiste (23) Bereiche unterschiedlicher Transparenz aufweist.

9. Toilettensitz nach einem der vorhergehenden Ansprüche,
**dadurch gekennzeichnet, dass**
der Toilettensitz (1) einteilig oder als Gehäuse (8) oder mit einem Gehäuse (8) mit wenigstens einem unteren (9) und wenigstens einem oberen (10) Gehäuseteil ausgebildet ist, wobei zwischen dem unteren (9) und dem oberen (10) Gehäuseteil zumindest abschnittweise ein transparenter oder teiltransparenter Gehäuseabschnitt (11), insbesondere die Leiste (12) und/oder die Lichtleiste (23) und/oder ein Wandabschnitt (5), angeordnet ist, wobei der transparente oder teiltransparente Wandabschnitt (5) eine gegenüber der übrigen Wandung (4), insbesondere dem wenigstens einen unteren (9) und/oder dem wenigstens einen oberen (10) Gehäuseteil, eine erhöhte Lichtdurchlässigkeit aufweist, wobei insbesondere die übrige Wandung (4) und/oder der wenigstens eine untere Gehäuseteil (9) und/oder der wenigstens eine obere (10) Gehäuseteil lichtundurchlässig sind.

10. Toilettensitz nach einem der vorhergehenden Ansprüche,
**dadurch gekennzeichnet, dass**
die äußere nutförmige Ausnehmung (20) sich wenigstens entlang einer vorderen und seitlichen äußeren Peripherie (19) des Toilettensitzes (1) erstreckt.

11. Toilettensitz nach einem der vorhergehenden Ansprüche,
**dadurch gekennzeichnet, dass** die äußere nutförmige Ausnehmung (19 und/oder die innere nutförmige Ausnehmung und/oder die Lichtleiste (23) in einem unteren Abschnitt des Toilettensitzes (1) und gegebenenfalls in einem Winkel zur Vertikalen angeordnet ist, so dass im Gebrauch Licht aus der jeweiligen Ausnehmung und/oder der Lichtleiste (23) im Wesentlichen nach unten in Richtung eines Bodens und/oder in das Innere der Toilettenschüssel (2), insbesondere blendfrei, abgestrahlt wird.

12. Toilettensitz nach einem der vorhergehenden Ansprüche,
**dadurch gekennzeichnet, dass** die äußere nutförmige Ausnehmung (19 und/oder die innere nutförmige Ausnehmung und/oder die Lichtleiste (23) entlang der äußeren (19) und/oder inneren Peripherie (22) des Toilettensitzes (1) linienförmig, insbesondere im Wesentlichen geradlinig linear, wellenförmig, mäanderförmig, geschwungen oder zickzackförmig verläuft.

13. Toilettensitz nach einem der vorhergehenden Ansprüche,
**dadurch gekennzeichnet, dass** das Leuchtmittel wenigstens eine LED, vorzugsweise ein LED-Band mit einer Vielzahl voneinander beabstandet angeordneter LEDs, und/oder ein Lichtleiter mit einer oder mehrere Lichtquellen und/oder eine Lichtröhre ist.

14. Toilettensitz nach einem der vorhergehenden Ansprüche,
**dadurch gekennzeichnet, dass** das Leuchtmittel (7) mittels eines Sensors, beispielsweise Licht- und/oder Dämmerungssensors, und/oder mittels Fernbedienung steuerbar sowie gegebenenfalls dimmbar ist.

15. Toilettensitz nach einem der vorhergehenden Ansprüche 5 bis 14,
**dadurch gekennzeichnet, dass** Licht durch die Leiste (12) und/oder durch die Lichtleiste (23) gleichmäßig und homogen abgestrahlt wird.

16. Sanitäreinrichtung, insbesondere Toilette, mit einem Toilettensitz (1) gemäß einem der vorhergehenden Ansprüche.

17. Sanitäreinrichtung, insbesondere Toilette, nach Anspruch 16, mit einem Toilettendeckel (13), dessen vorderer und/oder seitlicher unterer Rand (14) in geschlossenem Zustand beabstandet zu einer Toilettenschüssel (2) angeordnet ist, so dass von dem Toilettensitz (1) abgestrahltes Licht durch einen Spalt (15) zwischen Toilettendeckel (13) und Toilettenschüssel (2) strahlt.
